# EUROPEAN PATENT APPLICATION

(11) **EP 3 032 548 A1**
(43) Date of publication of application: **15.06.2016**
(21) Application number: 14834164.7
(22) Date of filing: 24.07.2014
(51) Int. Cl.: H01B 13/00, H01B 5/14, C08J 7/06

(54) **METHOD OF FORMING CONDUCTIVE PATTERN THROUGH DIRECT IRRADIATION OF ELECTROMAGNETIC WAVES, AND RESIN STRUCTURE HAVING CONDUCTIVE PATTERN**

(30) Priority: 09.08.2013 KR 20130094867
(71) Applicant: LG Chem, Ltd., Seoul 07336 (KR)
(72) Inventor: KIM, Jae Hyun, Daejeon 305-738 (KR); KIM, Jae Jin, Daejeon 305-738 (KR); PARK, Cheol-Hee, Daejeon 305-738 (KR); PARK, Chee-Sung, Daejeon 305-738 (KR); JUN, Shin Hee, Daejeon 305-738 (KR); JUNG, Sang Yun, Daejeon 305-738 (KR); JEONG, Han Nah, Daejeon 305-738 (KR)
(74) Representative: Goddar, Heinz J.
(86) International application number: PCT/KR2014/006756
(87) International publication number: WO 2015/020332

(57) **Abstract**

Provided are a method for forming conductive pattern by direct radiation of an electromagnetic wave capable of forming fine conductive patterns on various kinds of polymer resin products or resin layers by a simplified process, even without containing specific inorganic additives in the polymer resin itself, and a resin structure having the conductive pattern formed thereon.

The method for forming the conductive pattern by direct radiation of the electromagnetic wave includes: forming a first region having a predetermined surface roughness by selectively radiating the electromagnetic wave on a polymer resin substrate; forming a conductive seed on the polymer resin substrate; forming a metal layer by plating the polymer resin substrate having the conductive seed formed thereon; and removing the conductive seed and the metal layer from a second region of the polymer resin substrate, wherein the second region has surface roughness smaller than that of the first region.

## Description

### [Technical Field]

The present invention relates to a method for forming conductive pattern by direct radiation of an electromagnetic wave capable of forming fine conductive patterns on various kinds of polymer resin products or resin layers by a simplified process, even without containing specific inorganic additives in the polymer resin itself, and a resin structure having the conductive pattern formed therefrom.

### [Background Art]

In recent years, as a fine electronic technology is developed, demand for a structure in which fine conductive patterns are formed on a surface of polymer resin substrates (or products) of various kinds of resin products or resin layers, and the like has been increased. The conductive patterns on the surface of the polymer resin substrate and the structure may be applied to form various targets such as antennas integrated into a cellular phone case, various kinds of sensors, MEMS structures, RFID tags, and the like.

In particular, recent portable devices such as a smart phone, and the like, need to have simultaneously mounted local area network functions such as communication, bluetooth, Wi-Fi, electronic payment, and the like, unlike the existing cellular phone, and the like, and due to this reason, it is required to simultaneously mount various antennas in one smart phone. However, since aesthetic design aspect of the portable devices such as the smart phone, and the like, in addition thereto, is emphasized, a method for forming conductive pattern capable of serving as various antennas on the surface of the polymer resin substrate such as the case of the portable devices, and the like, has been continuously suggested and researched so as to simultaneously meet these demands.

As the interest in the technology of forming conductive patterns on the surface of the polymer resin substrate has been increased, several technologies regarding this were suggested. For example, a method for forming conductive pattern on a polymer resin substrate by blending and molding specific inorganic additives containing transition metals such as copper, chrome, and the like, (for example, CuCr₂O₄ having the spinel structure, and the like} in a polymer resin chip to form a polymer resin substrate, directly radiating an electromagnetic wave such as a laser, and the like, on a predetermined region, and plating the laser radiated region to form a metal layer was suggested. In this method, the inorganic additive-derived components in the laser radiated region are exposed and function as a seed for a kind of plating, such that the metal layer and conductive patterns may be formed.

However, since a substantial amount of high priced and specific inorganic additives should be used in the method for forming the conductive pattern, there is a disadvantage in that the total manufacturing cost is increased. In addition, since the inorganic additive needs to be blended into the polymer resin chip itself, the inorganic additive may deteriorate physical properties such as mechanical properties, and the like, of the polymer resin substrate or resin products formed therefrom. Further, the specific inorganic additives such as CuCr₂O₄ having the spinel structure, and the like, have significantly dark color itself, such that the specific inorganic additives may be deteriorating factors in implementing the polymer resin substrates or the resin products containing the specific inorganic additives with colors desirable to consumers. For example, in order to implement the polymer resin substrate containing the inorganic additives to have desirable colors, a large amount of pigment should be used, and it is not easy to implement white color.

Due to the disadvantages, a technology capable of forming fine conductive patterns by a simplified process on various kinds of the polymer resin products or the resin layers even without containing the specific inorganic additives in the polymer resin itself has been demanded.

### [Summary of Invention]

### [Technical Problem]

The present invention provides a method for forming conductive pattern by direct radiation of an electromagnetic wave capable of forming fine conductive patterns on various kinds of polymer resin products or resin layers by a simplified process, even without containing specific inorganic additives in the polymer resin itself.

In addition, the present invention provides a resin structure having the conductive pattern obtained by the method of forming the conductive pattern.

### [Solution to Problem]

An exemplary embodiment of the present invention provides a method for forming conductive pattern by direct radiation of an electromagnetic wave, the method including: forming a first region having a predetermined surface roughness by selectively radiating the electromagnetic wave on a polymer resin substrate; forming a conductive seed on the polymer resin substrate; forming a metal layer by plating the polymer resin substrate having the conductive seed formed thereon; and removing the conductive seed and the metal layer from a second region of the polymer resin substrate, wherein the second region has surface roughness smaller than that of the first region.

In addition, the surface roughness of the first and second regions may be defined by other methods. For example, when a cross-cut test having an interval of 2 mm or less according to ISO 2409 standard method is conducted by using a tape having adhesion of 4.0 to 6.0N/10mm width, the first region of the polymer resin substrate may have a surface roughness defined by adhesion at which a delamination area of a target metal layer under test corresponds to about 5% or less of an area of the metal layer, and when the same test is conducted on the remaining second region, the remaining second region of the polymer resin substrate may have a surface roughness defined by adhesion at which a delamination area of the target metal layer under test corresponds to 65% or more of an area of the metal layer.

Another exemplary embodiment of the present invention provides a resin structure having conductive pattern including: a polymer resin substrate including a first region formed to have a predetermined surface roughness and a second region having surface roughness smaller than that of the first region; and a conductive seed and a metal layer selectively formed on the first region of the polymer resin substrate.

### [Advantageous Effects of Invention]

According to the present invention, even though high priced and specific inorganic additives such as CuCr₂O₄ having a spinel structure, and the like, are not contained in a polymer resin substrate itself, surface roughness and adhesion to a metal layer, of a region in which conductive patterns are formed by radiating an electromagnetic wave such as laser, or the like, may be adjusted, such that the conductive patterns may be formed on the polymer resin substrate by a simplified process.

Therefore, the manufacturing cost of the process of forming the conductive patterns may be decreased, and deterioration of physical properties such as mechanical properties, dielectric constant, and the like, of the polymer resin substrate or products caused by the specific inorganic additive, a high power electromagnetic wave radiation, or the like, may be minimized. In addition, since desirable fine conductive patterns may be formed on the polymer resin substrate without using the specific inorganic additive, colors of the resin itself may be clearly shown, and it is easy to implement colors of the polymer resin substrate or products to be desirable colors.

Therefore, by using the method for forming the conductive pattern, conductive patterns for antenna, RFID tags, various kinds of sensors, MEMS structures, and the like, may be significantly effectively formed on various kinds of resin products such as a smart phone case, and the like.

### [Brief Description of Drawings]

FIG. 1 is a diagram schematically showing one example of a method for forming conductive pattern by directly radiation of an electromagnetic wave according to an exemplary embodiment of the present invention in a process-sequence.
FIG. 2a shows a photograph showing a state in which a predetermined region has surface roughness by radiating laser to the polymer resin substrate (first photograph), a photograph showing a state in which a copper metal layer is formed by electroless plating after radiating laser (second photograph), and a photograph showing a state in which plating layers are removed from the remaining region which is not radiated by laser, by selective delamination or removal after the electroless plating (third photograph), in the method for forming the conductive pattern of Example 1.
FIG. 2b is an optical microscope photograph of the laser radiated region having surface roughness according to Example 1.
FIG. 2c is a scanning electron microscope (SEM) photograph showing a portion in which the metal layer (conductive patterns) is formed in Example 1, wherein a conductive seed is grown, and the metal layer is formed on the conductive seed by plating.
FIG. 3 is a photograph showing a state in which the conductive patterns are formed on the polymer resin substrate by selectively removing the metal layer, and the like, from the region which is not radiated by laser in the method for forming the conductive pattern of Example 9.
FIG. 4a is a photograph showing color change depending on height using optical profiler in the laser radiated region of Example 6 (left), and is a photograph showing the color change in three dimensional structure (right).
FIG. 4b is a photograph showing color change depending on height using optical profiler in the laser radiated region of Example 8 (left), and is a photograph showing the color change in three dimensional structure (right).

### [Description of Embodiments]

Hereinafter, a method for forming conductive pattern by direct radiation of an electromagnetic wave according to a specific exemplary embodiment of the present invention, and a resin structure having the conductive patterns formed therefrom will be described.

According to an exemplary embodiment of the present invention, the method for forming conductive pattern by direct radiation of an electromagnetic wave, the method including: forming a first region having a predetermined surface roughness by selectively radiating the electromagnetic wave on a polymer resin substrate; forming a conductive seed on the polymer resin substrate; forming a metal layer by plating the polymer resin substrate having the conductive seed formed thereon; and removing the conductive seed and the metal layer from a second region of the polymer resin substrate, wherein the second region has surface roughness smaller than that of the first region.

According to the exemplary embodiment of the present invention, first, a surface structure having a shape such as concavo-convex, predetermined patterned, amorphous shape, or the like, is formed so that a polymer resin substrate of the first region has a predetermined surface roughness by radiating an electromagnetic wave such as laser, or the like, on a first region in which the conductive patterns are formed. In the first region, adhesion between a surface of the polymer resin substrate and a metal layer to be formed by plating in the first region may be improved due to the predetermined surface roughness.

Meanwhile, in a second region which is not radiated by the electromagnetic wave such as laser, or the like, poor adhesion between the surface of the polymer resin substrate and the metal layer in the second region may be shown due to original surface property of the polymer resin substrate itself.

Accordingly, when a conductive seed for facilitating a plating process is formed on the polymer resin substrate of the first region and the plating process is performed, the metal layer having excellent adhesion with the polymer resin substrate may be favorably formed on the first region; meanwhile, the metal layer which is easily removed due to poor adhesion may be formed on the second region. Therefore, when weak physical power is applied to the polymer resin substrate to selectively remove the metal layer and the conductive seed of the second region, desired conductive patterns may be easily formed on the polymer resin substrate.

As described above, according to an exemplary embodiment of the present invention, for example, even though high priced specific inorganic additives such as CuCr₂O₄, and the like, having the spinel structure are not contained in the polymer resin substrate itself, surface roughness, adhesion, and the like, of the region in which the conductive patterns are formed by radiating the electromagnetic wave such as laser, or the like, may be adjusted, such that the conductive patterns may be formed on the polymer resin substrate by a simplified process.

Therefore, the manufacturing cost of the process of forming the conductive patterns may be decreased, and deterioration of physical properties such as mechanical properties, and the like, of the polymer resin substrate or products caused by the specific inorganic additive, may be minimized. In addition, since desirable fine conductive patterns may be formed on the polymer resin substrate without using the specific inorganic additive, colors of the resin itself may be clearly shown, and it is easy to implement colors of the polymer resin substrate or products to be desirable colors.

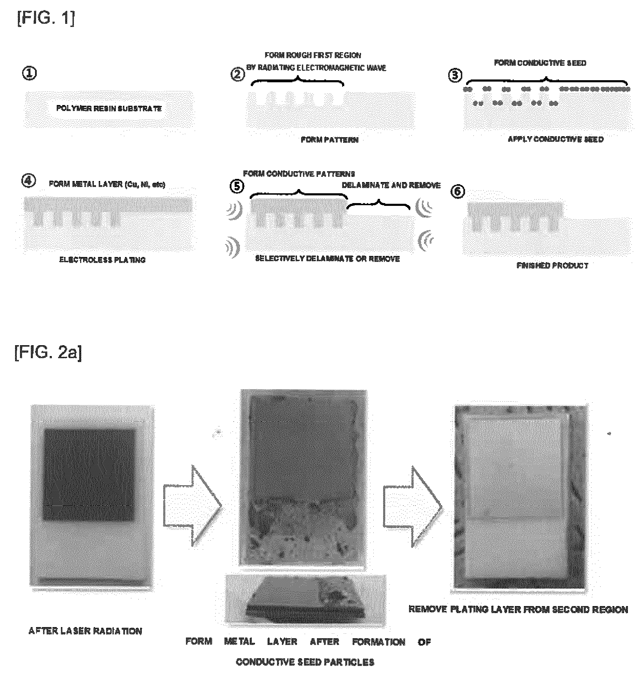

Meanwhile, hereinafter, the method for forming the conductive pattern by direct radiation of an electromagnetic wave according to an exemplary embodiment of the present invention is more specifically described for each process step with reference to drawings. FIG. 1 is a diagram schematically showing one example of a method for forming conductive pattern by direct radiation of an electromagnetic wave according to an exemplary embodiment of the present invention in a process-sequence.

As shown in ① and ② of FIG. 1, in the method for forming the conductive pattern according to an exemplary embodiment, the first region having a predetermined surface roughness is firstly formed by selectively radiating an electromagnetic wave on the polymer resin substrate.

The polymer resin substrate may be formed by using any thermosetting resin or any thermoplastic resin. Specific examples of the polymer resins capable of forming the polymer resin substrate such as the thermosetting resin or the thermoplastic resin may include an ABS resin, a polyalkylene terephthalate resin such as a polybutylene terephthalate resin, a polyethylene terephthalate resin, or the like, a polycarbonate resin, a polypropylene resin, a polyphthalamide resin, and the like, and in addition thereto, the polymer resin substrate may be formed by using various polymer resins.

In addition, the polymer resin substrate may be formed of the above-described polymer resin; however, may further contain additives, for example, an UV stabilizer, a heat stabilizer, or an impact reinforcing agent, generally used to form the polymer resin product, as needed. The additives may be contained in an appropriate amount of about 2 wt% or less, or about 0.01 to 2 wt%, based on the weight of the total polymer resin substrate. Meanwhile, the polymer resin substrate does not have to include the specific inorganic additives such as CuCr₂O₄ having a spinel structure, and the like, used to form the conductive patterns by radiating the electromagnetic wave which are known in the art.

Meanwhile, the first region has a predetermined surface roughness by radiating an electromagnetic wave such as laser, or the like, on the above-described polymer resin substrate, wherein in the first region having the surface roughness, relatively standardized patterns such as hole, mesh pattern, or the like, or concavo-convex shapes may be formed, or amorphous surface structure in which a plurality of irregular holes, patterns, or concavo-convex are complexly formed may be formed, and the polymer resin substrate of the first region may have a predetermined surface roughness due to the various surface shapes or structures.

As an example, in order to secure excellent adhesion between the metal layer (conductive patterns) to be formed in the first region and the surface of the polymer resin substrate, the first region of the polymer resin substrate may have surface roughness defined by a center line arithmetic average roughness of the absolute values (Ra) of about 500nm or more, or about 1µm or more, or about 1 to 3µm, and the second region which is not radiated by the electromagnetic wave may have surface roughness defined by a center line arithmetic average roughness of the absolute values (Ra) having surface roughness smaller than that of the first region, for example, about 400nm or less, or about 100nm or less, or about 0 to 90nm.

In addition, the above-described surface roughness may also be defined by other methods. For example, the surface roughness of the first and second regions may be defined by degree of adhesion to the metal layer measured in a cross-cut test according to ISO 2409 standard method. For example, when a cross-cut test having an interval of 2 mm or less according to ISO 2409 standard method is conducted by using a tape having adhesion of 4.0 to 6.0N/10mm width, the first region of the polymer resin substrate may have a surface roughness defined by adhesion (for example, ISO class 0 or 1) in which a delamination area of the target metal layer under test corresponds to about 5% or less of an area of the metal layer, and when a cross-cut test having an interval of 2 mm or less according to ISO 2409 standard method is conducted by using a tape having adhesion of 4.0 to 6.0N/10mm width, the second region of the polymer resin substrate may have a surface roughness defined by adhesion (for example, ISO class 5 or more) in which a delamination area of the target metal layer under test corresponds to 65% or more of an area of the metal layer.

As the polymer resin substrate of the first region has the above-described surface roughness by radiating the electromagnetic wave such as laser, or the like, when the metal layer is formed on the first region in the following plating process, thee metal layer may be formed and maintained on the polymer resin substrate with excellent adhesion, to form excellent conductive patterns. As compared to the first region, as the polymer resin substrate of the second region which is not radiated by an electromagnetic wave such as laser, or the like, has the above-described surface roughness due to surface property itself, when the metal layer is formed in the following plating process, the second region may have significantly low adhesion to be easily removed. As a result, the metal layer of the second region may be easily and selectively removed to form the conductive patterns on the polymer resin substrate of the first region.

Meanwhile, an electromagnetic wave such as laser, or the like, may be radiated under predetermined conditions as described below so that the polymer resin substrate of the first region has the above-described surface roughness.

First, in the radiating of the electromagnetic wave, laser electromagnetic wave may be radiated, for example, laser electromagnetic wave having a wavelength of 248 nm, about 308nm, about 355nm, about 532nm, about 585nm, about 755nm, about 1064nm, about 1070nm, about 1550nm, about 2940nm or about 10600nm may be radiated. In another example, laser electromagnetic wave having a wavelength in infrared ray (IR) region may be radiated.

In addition, specific conditions at the time of radiating the laser electromagnetic wave may be controlled or changed depending on kinds of the resin, physical properties, thickness, of the polymer resin substrate, kinds or thickness of the metal layer to be formed, or appropriate level of adhesion in consideration of the above-mentioned factors. Meanwhile, the laser electromagnetic wave may be radiated under radiation condition that an average power is about 0.1 to 50W, or about 1 to 30W, or about 5 to 25W, so that the polymer resin substrate of the first region has a predetermined surface roughness as described above.

In addition, the radiating of the laser electromagnetic wave may be radiated once by a relatively high power, but the laser electromagnetic wave may be radiated two or more times by a relatively low power. As the number of radiating the laser electromagnetic wave is increased, the surface roughness is increased, structures such as concavo-convex, and the like, formed on the surface may be changed from hole shaped patterns to mesh patterned or amorphous surface structures. Therefore, by controlling the condition and the number of radiating the laser electromagnetic wave, appropriate surface structure may be formed on the polymer resin substrate of the first region, and the surface roughness having an appropriate degree and excellent adhesion with the metal layer may be provided.

In addition, at the time of radiating the laser electromagnetic wave, radiation trace of the electromagnetic wave may be formed in a hole shape on the polymer resin substrate depending on an radiation interval at the time of radiating the laser electromagnetic wave. However, in order that the polymer resin substrate of the first region has the above-mentioned appropriate surface roughness, it is preferred that the laser electromagnetic wave may be radiated so that an interval between central parts of radiation trace of the electromagnetic wave, or an radiation interval of the electromagnetic wave is about 20 µm or more, or about 20 to 70 µm, but is not particularly limited thereto. As a result, the polymer resin substrate of the first region may have appropriate surface roughness and appropriate adhesion between the polymer resin substrate and the metal layer.

Meanwhile, as described above, after radiating the electromagnetic wave such as laser, or the like, on the first region, a conductive seed may be formed on the polymer resin substrate as shown in ③ of FIG. 1. The conductive seed is grown on the polymer resin substrate at the time of plating, and promotes formation of the metal layer by the plating. Accordingly, more excellent metal layer and the conductive patterns may be appropriately formed on the polymer resin substrate of the first region.

The conductive seed may contain metal nanoparticles, metal ions, or metal complex ions. In addition, the metal ion or the metal complex ion may be used as ion itself or as metal-containing compounds to which the metal ions are coupled or as metal complexes containing metal complex ions, or even as particles of the metal-containing compounds or the metal complexes.

The kind of the metal atoms included in the conductive seed is not particularly limited as long as the metal atom has conductivity. For example, the conductive seed may include at least one kind metal selected from the group consisting of copper (Cu), platinum (Pt), palladium (Pd), silver (Ag), gold (Au), nickel (Ni), tungsten (W), titanium (Ti), chromium (Cr), aluminum (Al), zinc (Zn), tin (Sn), lead (Pb), magnesium (Mg), manganese (Mn) and iron (Fe), ions or complex ions thereof.

In addition, in order to form the conductive seed on the polymer resin substrate, the conductive seed, a dispersion liquid or solution containing the above-mentioned conductive seed such as the metal nanoparticles, the metal ions, or the metal complex ions may be applied on the polymer resin substrate, followed by methods such as a precipitating method, a drying method, and/or a reducing method, to thereby form the conductive seed in a particle form. More specifically, when the dispersion liquid, or the like, contains the metal nanoparticles, the metal nanoparticles are precipitated by difference in solubility and dried to form the conductive seed in a particle form, and when the dispersion liquid, or the like, contains the metal ions, or the metal complex ions (or the metal compounds or the complexes containing these ions; for example, the metal compounds or the complexes such as AgNO₃, Ag₂SO₄, KAg(CN)₂), the metal ions, or the metal complex ions are reduced and dried to appropriately form the conductive seed in a particle form.

Here, the reducing of the metal ion or the metal complex ion may be performed by using general reducing agents, for example, at least one kind reducing agent selected from the group consisting of an alcohol-based reducing agent, an aldehyde-based reducing agent, hypophosphorous acid-based reducing agent such as hypophosphorous acid sodium or hydrates thereof, or the like, hydrazine-based reducing agent such as hydrazine or hydrates thereof, or the like, sodium borohydride and lithium aluminum hydride.

In addition, the dispersion liquid or the solution may appropriately include an aqueous-based polymer solution (for example, solution containing polyvinylpyrrolidone-based polymer, and the like) capable of improving close adhesion between the polymer resin substrate and the conductive seed, or an aqueous-based complexing agent (for example, NH₃, EDTA, Rochelle salt, or the like) capable of stabilizing the metal ions or the metal complex ions, as a liquid-phase medium.

Further, the dispersion liquid or the solution of the conductive seed may be applied by general processes for applying a liquid-phase composition to the polymer resin substrate, for example, methods such as dipping, spin coating, spraying, and the like.

The conductive seed formed as described above may be formed on the entire surface of the polymer resin substrate including space between the surface concavo-convex, patterns, or surface structures formed on the first region, and may serve to promote favorable formation of the metal layer in the plating process and to control plating rate or physical properties of the metal layer.

Meanwhile, right after the radiating of the electromagnetic wave as described above, the process of forming the conductive seed is immediately performed; however, after the polymer resin substrate is selectively surface-treated with a surfactant having a surface tension lower than that of the dispersion liquid or solution, the process of forming the conductive seed may be performed. In addition, the polymer resin substrate may be surface-treated in a state in which the surfactant is added to the dispersion liquid or the solution itself for forming the conductive seed. Here, the surfactant may have surface tension lower than that of the dispersion liquid or the solution before the surfactant is added.

The surfactant may allow the conductive seed to be more uniformly formed and maintained on the surface of the polymer resin substrate, in particular, between the surface concavo-convex, patterns, or surface structures. The reason is because the surfactant removes air between the surface structures to assist the conductive seed in being easily permeated between the surface structures. Therefore, when the treatment with the surfactant is added, the conductive seed is favorably absorbed entirely onto the first region, and the metal layer may be more uniformly and favorably formed by the plating process. In addition, due to the treatment with the surfactant and the formation of the conductive seed, adhesion between the metal layer and the polymer resin substrate on the first region may be more improved to favorably form the conductive patterns having excellent conductivity.

Kinds of the surfactant may differ depending on kinds of the dispersion liquid or the solution of the conductive seed as described above, and may include any liquid phase medium having surface tension lower than that of the dispersion liquid or the solution. For example, organic solvents such as ethanol, and the like, having relatively low surface tension may be used as the surfactant.

In addition, the surfactant may be treated by a method of immersing the polymer resin substrate for several seconds to several minutes, and the like.

Meanwhile, referring to ④ of FIG. 1, after the conductive seed is formed on the polymer resin substrate, the metal layer may be formed by plating the polymer resin substrate having the conductive seed formed thereon. The process of forming the metal layer may be performed by electroless-plating the conductive metal on the polymer resin substrate, and methods and conditions of performing the electroless-plating process may be conducted by general methods and conditions.

For example, the plating process is performed by using a plating solution containing conductive metals consisting of the metal layer, for example, metal sources such as copper, and the like, complexing agents, pH adjustors, reducing agent, and the like, to form the metal layer on the polymer resin substrate including the first region and the second region. Here, the metal layer may be formed on the grown conductive seed as described above.

The metal layer may be favorably formed on the first region by excellent adhesion; meanwhile, the metal layer may be easily removed from the second region due to poor adhesion to the polymer resin substrate (for example, as shown in second photograph of FIG. 2a, the metal layer may be delaminated from the polymer resin substrate).

After the metal layer is formed, the conductive seed and the metal layer may be selectively removed from the second region of the polymer resin substrate to form the conductive patterns on the remaining first region as shown in ⑤ and ⑥ of FIG. 1.

As described above, since the metal layer is formed on the second region in a state in which it is significantly easy to remove the metal layer, the metal layer and the conductive seed may be selectively removed from the second region by simple methods such as applying weak physical power to the polymer resin substrate, and the like. Here, due to excellent adhesion between the metal layer and the polymer resin substrate on the first region, the metal layer may remain to form the conductive patterns.

As described above, the process of removing the conductive seed and the metal layer from the second region, may be performed by any method of applying weak physical power onto the polymer resin substrate such as ultrasonic radiation (sonication), liquid phase washing, liquid phase rinsing, air blowing, taping, brushing, and methods of using a manpower such as directly dusting or wiping with hands, or by a combination of two or more method(s) selected therefrom.

For example, washing or rinsing is performed in water under the ultrasonic radiation for a predetermined time, and air blowing, and the like, are performed, such that the conductive seed and the metal layer of the second region may be selectively removed.

The resin structure having the conductive pattern formed by the above-described method may include the polymer resin substrate divided into the first region formed to have a surface roughness defined by a center line arithmetic average roughness of the absolute values (Ra) of about 500 nm or more and the second region having a surface roughness smaller than that of the first region; and the conductive seed and the metal layer selectively formed on the first region of the polymer resin substrate.

Here, since the surface roughness of the first and second regions is sufficiently described in the method according to an exemplary embodiment, additional description thereof will be omitted. In addition, as described above, the first region may correspond to a region in which the electromagnetic wave such as laser, or the like, is radiated.

The resin structure as described above may be various kinds of resin products or resin layers such as a smart phone case, and the like, having conductive patterns for antenna, or may be various kinds of resin products or resin layers having conductive patterns such as other RFID tags, various kinds of sensors, or MEMS structures, and the like.

As described above, according to the present invention, even though high priced and specific inorganic additives such as CuCr₂O₄ having a spinel structure, and the like, are not contained in a polymer resin substrate itself, surface roughness and adhesion to a metal layer, of a region in which conductive patterns are formed by radiating an electromagnetic wave such as laser, or the like, may be adjusted, such that the conductive patterns may be formed on the polymer resin substrate by a simplified process

Therefore, the manufacturing cost of the process of forming the conductive patterns and the cost of raw materials may be decreased, and deterioration of physical properties such as mechanical properties, and the like, of the polymer resin substrate or products caused by the specific inorganic additive, may be minimized. In addition, since desirable fine conductive patterns may be formed on the polymer resin substrate without using the specific inorganic additive, colors of the resin itself may be clearly shown, and it is easy to implement colors of the polymer resin substrate or products to be desirable colors. Therefore, according to exemplary embodiments of the present invention, fine conductive patterns may be formed on various kinds of resin products or resin layers at lower manufacturing cost and by a simplified process, such that resin products having various colors and shapes, including new resin products which have not been suggested before, may be implemented.

Hereinafter, action and effects of the present invention are described by specific examples of the present invention in detail. Meanwhile, these examples are provided by way of example, and therefore, should not be construed as limiting the scope of the present invention.

### Example1: Formation of conductive patterns by laser direct radiation

A polycarbonate resin substrate containing an UV stabilizer, a thermal stabilizer, and an impact reinforcing agent having a total amount of less than 2 wt%, without containing other different inorganic additives was prepared. Laser having a wavelength of 1064nm was radiated once onto a predetermined region of the polycarbonate resin substrate under radiation condition having an average power of 21.4W. Here, the interval between central parts of the laser radiation trace of the polycarbonate resin was controlled to be about 35 µm by controlling the radiation interval of the laser.

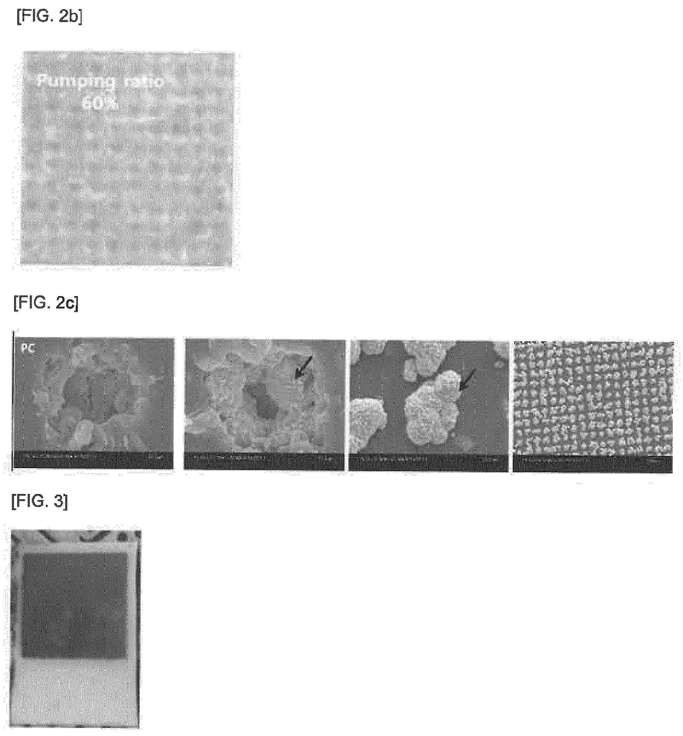

Accordingly, the polycarbonate resin substrate radiated by the laser had a predetermined surface roughness on the predetermined region. A photograph of the polycarbonate resin substrate as manufactured above was shown in the first photograph of FIG. 2a, and an optical microscope photograph of the region radiated by laser formed so as to have the surface roughness was shown in FIG. 2b.

Then, the polycarbonate resin substrate was immersed into an aqueous solution including Pd ions for about 5 minutes, to form a conductive seed including Pd on the substrate. Next, the substrate was washed with deionized water, and an elelctroless-plating was performed by using copper as a conductive metal. At the time of the electroless-plating, a plating solution containing copper source (copper sulfate), a complexing agent (Rochelle salt), a pH adjustor (sodium hydroxide aqueous solution), and a reducing agent (formaldehyde), was used. The electroless-plating was performed at room temperature for about 1 hour to form the metal layer.

A photograph showing the metal layer formed as described above was shown in the second photograph of FIG. 2a. Referring to FIG. 2a, it could be confirmed that the metal layer was favorably formed in the region radiated the laser; however, the metal layer in the remaining region was formed in a delamination state due to poor adhesion to be significantly easily removed.

Then, the substrate was immersed into the deionized water, followed by ultrasonic radiation (sonication) for 20 minutes, and air blowing, to selectively remove the metal layer of the region which is not radiated by laser. The third photograph of FIG. 2a is a photograph showing a state in which the metal layer, and the like, are selectively removed from the region which is not radiated by laser, to form conductive patterns on the substrate, and FIG. 2c is a scanning electron microscope (SEM) photograph showing a portion in which the conductive patterns are formed. Referring to FIG. 2c, it could be confirmed that the conductive seed was grown in the corresponding portion, and the metal layer was formed on the conductive sheet (conductive metal particles) by plating.

### Examples 2 to 8: Formation of conductive patterns by laser direct radiation

Resin structures of Examples 2 to 8 each having conductive patterns were manufactured by the same method as Example 1 except that the radiation condition of the average power of laser and the interval between central parts of radiation trace of laser in Example 1 are changed into about 15.7W and about 25µm (Example 2), about 15.7W and about 35µm (Example 3), about 18.6W and about 45µm (Example 4), about 21.4W and about 45µm (Example 5), about 21.4W and about 55µm (Example 6), about 24.2W and about 55µm (Example 7), about 28.5W and about 55µm (Example 8) in once radiation.

### Example 9: Formation of conductive patterns by laser direct radiation

Resin structure of Example 9 having conductive patterns was manufactured by the same method as Example 1 except that a mixture of ethanol and an aqueous-based complex ion solution (solution containing AgNO₃ and NH₃ which is a complexing agent) containing Ag complex ions instead of Pd was used as a solution for forming the conductive seed. FIG. 3 is a photograph showing a state in which the conductive patterns were formed on the substrate by selectively removing the metal layer, and the like, from the region which is not radiated by laser.

### Test Example 1: Evaluation of Surface Roughness of Conductive Patterns

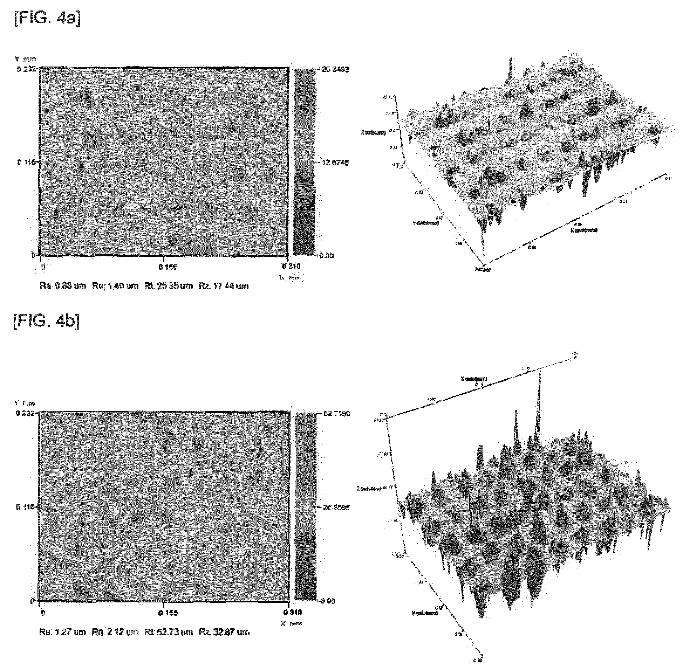

Surface roughness was measured on predetermined regions of the polycarbonate resin substrate radiated by laser according to Examples 1 to 9. The center line arithmetic average roughness of the absolute values (Ra) of an area of 0.2 mm X 0.3 mm was measured by using an optical profiler (Nano view E1000, Nanosystem, Korea). In FIG. 4a, color change depending on height was shown by using optical profiler in the region radiated by laser of Example 6 (left), and a photograph implementing the color change in three dimensional structure was shown (right). In addition, the measured surface roughness were also shown in FIG. 4a. FIG. 4b is a photograph showing Example 8 and shows change of surface state depending on change of the laser condition and changed values of surface roughness, respectively. Ra values obtained by measuring surface roughness at different six points of the region radiated by laser in Examples 1 to 9 using the above-described methods and averaging the measured values were summarized and shown in the following Table 1. For reference, FIGS. 4a and 4b show surface roughness measured at any one point among six points, and Table. 1 shows an average value of the values measured at six points.

### Test Example 2: Evaluation of Adhesion of Conductive Patterns

A cross-cut test was conducted by using a tape having adhesion of 4.0 to 6.0N/10mm width according to ISO 2409 standard method(3M scotch tape #371) in the region having the metal layer and the conductive patterns according to Examples 1 to 9 formed thereon. Here, adhesion or close adhesion between the substrate and the metal layer was tested by cutting the metal layer to be 10X10 graph (an interval of about 2 mm or less), and measuring area of the metal layer delaminated by attaching and detaching the tape.

Evaluation on adhesion of the delamination area of the conductive patterns was conducted under the following ISO class standard.
1. class 0: When the delamination area of the conductive patterns corresponds to 0% of area of target conductive patterns under evaluation.
2. class 1: When the delamination area of the conductive patterns corresponds to more than 0% to 5% or less of area of target conductive patterns under evaluation.
3. class 2: When the delamination area of the conductive patterns corresponds to more than 5% to 15% or less of area of target conductive patterns under evaluation.
4. class 3: When the delamination area of the conductive patterns corresponds to more than 15% to 35% or less of area of target conductive patterns under evaluation.
5. class 4: When the delamination area of the conductive patterns corresponds to more than 35% to 65% or less of area of target conductive patterns under evaluation.
6. class 5 : When the delamination area of the conductive patterns corresponds to more than 65% of area of target conductive patterns under evaluation.

In addition, uniformity of the metal layer (conductive patterns) after the conductive patterns were formed in Examples 1 to 9 was evaluated under the following standards.
1. ○: With the unaided eye, uniformly colored metal layer (plated thin film) is formed in all regions having surface roughness formed by laser radiation, and when observing the surface of the metal layer by optical microscopy, pores are not shown.
2. Δ: With the unaided eye, uniformly colored metal layer (plated thin film) is formed in all regions having surface roughness formed by laser radiation; however, when observing the surface of the metal layer by optical microscopy, pores are partially shown.
3. X: With the unaided eye, uniformly colored metal layer (plated thin film) is not formed in all regions having surface roughness formed by laser radiation; and when observing the surface of the metal layer by optical microscopy, pores are partially shown at least.

Evaluation results were shown in the following Table 1.

**[Table 1]**

| | Main Component of Conductive Seed | Evaluation on Uniformity of Metal Layer | Average Power of Laser (W) | Interval (µm) Between Central Parts of Laser Radiation Trace | Average Ra (nm) | ISO 2409 class |
|---|---|---|---|---|---|---|
| Example 1 | Pd | ○ | 21.4 | 35 | 1110 | 0 |
| Example 2 | Pd | ○ | 15.7 | 25 | 645 | 0 |
| Example 3 | Pd | Δ | 15.7 | 35 | 710 | 1 |
| Example 4 | Pd | O | 18.6 | 45 | 705 | 1 |
| Example 5 | Pd | O | 21.4 | 45 | 818 | 1 |
| Example 6 | Pd | ○ | 21.4 | 55 | 837 | 1 |
| Example 7 | Pd | ○ | 24.2 | 55 | 1275 | 0 |
| Example 8 | Pd | ○ | 28.5 | 55 | 3470 | 0 |
| Example 9 | Ag | ○ | 21.4 | 35 | 1110 | 0 |

Referring to Table 1, it could be confirmed that in Examples 1 to 9, significantly excellent metal layer (conductive patterns) could be selectively formed in the region radiated by laser, through the method including the process of forming surface roughness (Ra) of about 500 nm or more in the region radiated by laser to improve adhesion between the polymer resin substrate and the metal layer, and the process of forming the conductive seed, and the like. In particular, it could be confirmed that the conductive pattern has excellent uniformity and excellent adhesion to the polymer resin substrate, thereby being favorably formed.

In conclusion, according to Examples above, even though high priced and specific inorganic additives such as CuCr₂O₄, and the like, are not contained in the polymer resin substrate itself, surface roughness of the region in which conductive patterns are formed by radiating an electromagnetic wave such as laser, and the like, and adhesion to a metal layer, may be adjusted, such that the conductive patterns may be formed on the polymer resin substrate by a simplified process.

## Claims

1. A method for forming conductive pattern by direct radiation of an electromagnetic wave, the method comprising:
forming a first region having a predetermined surface roughness by selectively radiating the electromagnetic wave on a polymer resin substrate;
forming a conductive seed on the polymer resin substrate;
forming a metal layer by plating the polymer resin substrate having the conductive seed formed thereon; and
removing the conductive seed and the metal layer from a second region of the polymer resin substrate, wherein the second region has surface roughness smaller than that of the first region.

2. The method of claim 1, wherein the first region of the polymer resin substrate has surface roughness defined by a center line arithmetic average roughness of the absolute values (Ra) of 500 nm or more, and the second region has a center line arithmetic average roughness of the absolute values (Ra) smaller than that of the first region.

3. The method of claim 1, wherein when a cross-cut test having an interval of 2 mm or less according to ISO 2409 standard method is conducted by using a tape having adhesion of 4.0 to 6.0N/10mm width, the first region of the polymer resin substrate has surface roughness defined by adhesion at which a delamination area of a target metal layer under test corresponds to 5% or less of an area of the metal layer.

4. The method of claim 1, wherein when a cross-cut test having an interval of 2 mm or less according to ISO 2409 standard method is conducted by using a tape having adhesion of 4.0 to 6.0N/10mm width, the second region of the polymer resin substrate has surface roughness defined by adhesion at which a delamination area of a target metal layer under test corresponds to 65% or more of an area of the metal layer.

5. The method of claim 1, wherein the polymer resin substrate contains a thermosetting resin or a thermoplastic resin.

6. The method of claim 5, wherein the polymer resin substrate contains at least one kind selected from the group consisting of an ABS resin, a polyalkylene terephthalate resin, a polycarbonate resin, a polypropylene resin, and a polyphthalamide resin.

7. The method of claim 1, wherein the radiating of the electromagnetic wave is performed by radiating a laser electromagnetic wave having a wavelength of 248 nm, 308nm, 355nm, 532nm, 585nm, 755nm, 1064nm, 1070nm, 1550nm, 2940nm or 10600nm.

8. The method of claim 1, wherein the radiating of the electromagnetic wave is performed by radiating a laser electromagnetic wave under radiation condition having 0.1 to 50W of an average power.

9. The method of claim 1, wherein the radiating of the electromagnetic wave is performed by radiating a laser electromagnetic wave so that an interval between central parts of radiation trace of the electromagnetic wave shown on the polymer resin substrate is 20 to 70 µm.

10. The method of claim 1, wherein the radiating of the electromagnetic wave is performed by radiating a laser electromagnetic wave once or by radiating the laser electromagnetic wave two or more times.

11. The method of claim 1, wherein the conductive seed contains metal nanoparticles, metal ions, or metal complex ions.

12. The method of claim 11, wherein the conductive seed contains at least one kind metal selected from the group consisting of copper (Cu), platinum (Pt), palladium (Pd), silver (Ag), gold (Au), nickel (Ni), tungsten (W), titanium (Ti), chromium (Cr), aluminum (Al), zinc (Zn), tin (Sn), lead (Pb), magnesium (Mg), manganese (Mn) and iron (Fe), ions or complex ions thereof.

13. The method of claim 11, wherein the forming of the conductive seed includes:
applying a dispersion liquid or solution containing the metal nanoparticles, the metal ions, or the metal complex ions on the polymer resin substrate; and
precipitating and drying the metal nanoparticles, or reducing and drying the metal ions or the metal complex ions to form the conductive seed in a particle form.

14. The method of claim 13, wherein the reducing of the metal ions or the metal complex ions is performed in the presence of at least one kind reducing agent selected from the group consisting of an alcohol-based reducing agent, an aldehyde-based reducing agent, a hypophosphite-based reducing agent, a hydrazine-based reducing agent, sodium borohydride and lithium aluminum hydride.

15. The method of claim 13, further comprising: adding a surfactant having surface tension lower than that of the dispersion liquid or the solution in the forming of the conductive seed, or
surface-treating the polymer resin substrate with a surfactant having surface tension lower than that of the dispersion liquid or solution, between the radiating of the electromagnetic wave and the forming of the conductive seed.

16. The method of claim 1, wherein the forming of the metal layer includes electroless-plating a conductive metal on the polymer resin substrate.

17. The method of claim 1, wherein the removing of the conductive seed and the metal layer from the second region includes applying physical power onto the polymer resin substrate by combination of one or two or more method(s) selected from the group consisting of ultrasonic radiation (sonication), liquid phase washing, liquid phase rinsing, air blowing, taping, brushing, and a method of using a manpower.

18. A resin structure having conductive pattern comprising:
a polymer resin substrate including a first region formed to have a predetermined surface roughness and a second region having surface roughness smaller than that of the first region; and
a conductive seed and a metal layer selectively formed on the first region of the polymer resin substrate.

19. The resin structure of claim 18, wherein the first region corresponds to a region radiated by the electromagnetic wave.

20. The resin structure of claim 18, wherein the first region of the polymer resin substrate has surface roughness defined by a center line arithmetic average roughness of the absolute values (Ra) of 500 nm or more, and the second region has a center line arithmetic average roughness of the absolute values (Ra) smaller than that of the first region.

21. The resin structure of claim 18, wherein when a cross-cut test having an interval of 2 mm or less according to ISO 2409 standard method is conducted by using a tape having adhesion of 4.0 to 6.0N/10mm width, the first region of the polymer resin substrate has surface roughness defined by adhesion at which a delamination area of a target metal layer under test corresponds to 5% or less of an area of the metal layer.

22. The resin structure of claim 18, wherein when a cross-cut test having an interval of 2 mm or less according to ISO 2409 standard method is conducted by using a tape having adhesion of 4.0 to 6.0N/10mm width, the second region of the polymer resin substrate has surface roughness defined by adhesion at which a delamination area of a target metal layer under test corresponds to 65% or more of an area of the metal layer.
